# EUROPEAN PATENT APPLICATION

(11) **EP 4 576 221 A1**
(43) Date of publication of application: **25.06.2025**
(21) Application number: 23861996.9
(22) Date of filing: 28.06.2023
(51) Int. Cl.: H01L 27/15

(54) **MICROLED DISPLAY PANEL, DISPLAY DEVICE, AND MANUFACTURING METHOD**

(30) Priority: 05.09.2022 CN 202211079222
(71) Applicant: Huawei Technologies Co., Ltd., Shenzhen, Guangdong 518129 (CN)
(72) Inventor: CHEN, Minghui, Shenzhen, Guangdong 518129 (CN); ZHOU, Quanbin, Shenzhen, Guangdong 518129 (CN)
(74) Representative: Gill Jennings & Every LLP
(86) International application number: PCT/CN2023/103087
(87) International publication number: WO 2024/051295

(57) **Abstract**

This application discloses a MicroLED display panel and a manufacturing method therefor, and a display device. The MicroLED display panel includes a plurality of display structures, where each display structure includes a first electrode, a second electrode, a first semiconductor layer, a second semiconductor layer, and a light emitting layer; first electrodes, first semiconductor layers, and light emitting layers of adjacent display structures are independent of each other; the first semiconductor layer and the second semiconductor layer are respectively located on surfaces of two sides of the light emitting layer; the first electrode is located on a side that is of the first semiconductor layer and that is away from the light emitting layer, and the second electrode is located on a side that is of the second semiconductor layer and that is away from the light emitting layer; the light emitting layer of each display structure corresponds to one pixel region; and the second electrode is routed around each pixel region, and the second electrode is a common electrode of each pixel region, and is a metal barrier wall between adjacent pixel regions. This solution can increase an area of a light emitting region and improve light efficiency. **In** addition, massive transfer is not needed, and a qualification rate is improved. The second electrode serves as the metal barrier wall to prevent light crosstalk, which facilitates uniform distribution of a current and improves brightness uniformity.

## Description

This application claims priority to Chinese Patent Application No. 202211079222.8, filed with the China National Intellectual Property Administration on September 5, 2022 and entitled "MICROLED DISPLAY PANEL AND MANUFACTURING METHOD THEREFOR, AND DISPLAY DEVICE", which is incorporated herein by reference in its entirety.

### TECHNICAL FIELD

This application relates to the field of display screen technologies, and in particular, to a MicroLED display panel and a manufacturing method therefor, and a display device.

### BACKGROUND

Currently, as display technologies continuously develop, a micro light-emitting diode (MicroLED) becomes a new generation of popular display technology. The MicroLED has advantages such as ultra-high resolution, color saturation, flexible display, and a long service life, and can also be used as a pixelized array light source in fields such as photosensitivity, projection, and optical communication. Currently, the MicroLED with tens of thousands of pixels can be used in fields such as a smart headlight, augmented reality (AR, Augmented Reality), and virtual reality (VR, Virtual Reality). The MicroLED needs to develop toward miniaturization, high brightness, and integration.

Currently, a MicroLED chip with a flip-chip structure is mostly used in the industry. Because a process of a MiniLED with the flip-chip structure is mature, as long as a size of the chip is slightly reduced, the MicroLED can be produced. Then, MicroLED chiplets are transferred to a substrate through massive transfer, and finally bonding (bonding) is performed to connect a circuit. To enable each display unit to independently emit light, a barrier wall needs to be manufactured on the substrate to prevent optical crosstalk between display units.

However, because a part of a light emitting region of the MicroLED chip with the flip-chip structure needs to be etched to lead out an electrode, an area of the light emitting region is small. The massive transfer and bonding technologies are used to transfer the MicroLED chip from a wafer to the substrate, which imposes very high requirements on a chip qualification rate, a transfer qualification rate, a bonding qualification rate, and the like. Consequently, a total qualification rate cannot be effectively ensured, costs are high, and engineering is difficult to implement. In addition, a barrier wall process needs to be specially manufactured in a packaging process. The substrate is irregular in shape and has a non-uniform size, and therefore the barrier wall is difficult to be compatible with the device. In addition, a um-level lithography process on a packaging side is not mature enough, which causes risks of barrier wall collapse and optical crosstalk.

### SUMMARY

To resolve the foregoing technical problems, this application provides a MicroLED display panel and a manufacturing method therefor, and a display device, to ensure a product qualification rate, and a barrier wall does not need to be specially manufactured, thereby reducing a process flow.

This application provides a MicroLED display panel, including a plurality of display structures. Each display structure includes a first electrode, a second electrode, a first semiconductor layer, a second semiconductor layer, and a light emitting layer. First electrodes, first semiconductor layers, and light emitting layers of adjacent display structures are independent of each other. The first semiconductor layer and the second semiconductor layer are respectively located on surfaces of two sides of the light emitting layer. The first electrode is located on a side that is of the first semiconductor layer and that is away from the light emitting layer, and the second electrode is located on a side that is of the second semiconductor layer and that is away from the light emitting layer. The first electrode and the second electrode of the display panel are not horizontally disposed, but are vertically disposed. The first electrode and the second electrode are respectively located on an upper surface and a lower surface of the second semiconductor layer. In this way, a part of a light emitting region does not need to be etched to lead out the second electrode. The light emitting layer of each display structure corresponds to one pixel region. The second electrode is routed around each pixel region. Even if the light emitting region is arranged in an array, the second electrode is a common electrode of each pixel region, and the second electrode is configured to serve as a metal barrier wall between adjacent pixel regions. This prevents light crosstalk, and no barrier wall needs to be separately disposed. A process is simple, and is easy to implement in engineering. In addition, this also facilitates uniform current distribution and improves light uniformity. Moreover, massive transfer does not need to be performed for a vertical structure in a semiconductor process, so that a product qualification rate can be ensured.

An application scenario of the display panel is not specifically limited in this application. The display panel uses a MicroLED for display. The display panel may be used in a display screen of a device, for example, a display screen of an electronic device such as a mobile phone, or a display screen of a wearable device such as a watch. In addition, the application scenario may further be a scenario with a large current and high pixel density, for example, a device such as a smart vehicle light, an AR device, or a VR device. In addition, the MicroLED may also be used as a pixelized array light source in fields such as photosensitivity, projection, and optical communication.

In a possible implementation, a side surface of the second electrode is tilted, and a tilt angle range is 30 degrees to 150 degrees. A side wall of the second electrode is designed in a tilt manner, which helps collect light and improve light efficiency.

In a possible implementation, a side wall of the display structure is tilted, and a tilt angle range is 30 degrees to 150 degrees. The side wall of the display structure is tilted, and the tilt angle range is 30 degrees to 150 degrees. When the side wall is consistent with the tilt angle of the second electrode, light can be collected, and titling of the side wall helps drain a current and prevent current congestion.

In a possible implementation, to further isolate light between adjacent display structures, the second electrode in contact with the second semiconductor layer is partially or completely embedded into the second semiconductor layer.

In a possible implementation, a passivation layer is deposited on etched edges of the second semiconductor layer, the light emitting layer, and the first semiconductor layer. A side that is of the second electrode and that is embedded into the second semiconductor layer is in contact with the passivation layer.

In a possible implementation, the display panel further includes a transparent conductive layer that is disposed between the second semiconductor layer and the second electrode. The transparent conductive layer serves as a transition between the second electrode and the second semiconductor layer, which resolves a problem of ohmic contact between metal and a semiconductor, and can reduce a resistance value. In addition, the transparent conductive layer is distributed on an entire surface, which helps more uniformly extend a current, and can also improve the light efficiency, thereby avoiding a problem of uneven brightness and improving reliability of the display panel. In addition, the transparent conductive layer in combination with the second electrode routed in a pixelized manner can reduce a power, reduce a voltage, and reduce power consumption.

In a possible implementation, a side that is of the second electrode and that is in contact with the transparent conductive layer is at least partially embedded into the transparent conductive layer. Alternatively, a side that is of the second electrode and that is in contact with the transparent conductive layer is at least partially embedded into the transparent conductive layer and the second semiconductor layer. To improve light blocking effect of the second electrode, the second electrode may also be embedded into the transparent conductive layer, or may be embedded into the transparent conductive layer and the second semiconductor layer. A material of the transparent conductive layer is not specifically limited in this application. For example, indium tin oxide, indium zinc oxide, or the like may be selected for the transparent conductive layer.

In a possible implementation, to improve luminous efficiency and reduce light reflection, a surface of the side that is of the second semiconductor and that is away from the light emitting layer presents a crystal structure. For example, the crystal structure is in a sawtooth shape, a wave shape, or the like.

In a possible implementation, the first electrode is a surface electrode, and the first electrode wraps a surface and a side wall of the first semiconductor. The first electrode is the surface electrode that has functions of both an electric field and light reflection, so that a light emitting angle can be effectively reduced, light collection can be implemented, forward brightness of a chip can be improved, and light efficiency can be improved.

The display panel further includes a plurality of switches. Each display structure corresponds to one switch, and the first electrode is configured to connect to the corresponding switch. A status of the switch determines whether the light emitting layer emits light. Control of the switch is controlled by a drive circuit. The drive circuit may receive a control signal of a controller of a device. The CMOS is preferably used as a switch, for example, silicon Si CMOS. Silicon has good heat resistance and is especially suitable for application in a vehicle light scenario.

In a possible implementation, the second semiconductor layers of the display structures are communicated. The thickness of the second semiconductor layer at a joint of adjacent display structures may be greater than a coarsening depth, to prevent a chip from breaking.

In a possible implementation, the second semiconductor layers of the display structures are communicated. Both the first semiconductor layer and the second semiconductor layer are carrier transport layers. A charged polarity of the first semiconductor layer is the same as a polarity of the first electrode, and edge charges repel each other, which can effectively reduce side wall effect. A charged polarity of the second semiconductor layer is the same as a polarity of the second electrode. The second semiconductor layer is charged and is electrically opposite to the first electrode, and edge charges absorb each other, which facilitates extension of a current and improves efficiency.

In a possible implementation, the first electrode includes an ohmic electrode and a reflective electrode. The ohmic electrode is configured to connect to the first semiconductor layer. The reflective electrode is connected to a drive circuit, and the reflective electrode is further configured to reflect light.

The surface and the side wall of the first semiconductor layer may be provided with a reflection layer, and are wrapped by the reflection layer. The reflection layer is a thin film material having high reflectivity, for example, a metal reflector or a metal and distributed Bragg reflection composite layer.

In a possible implementation, a shape of the second electrode is any one of the following: a triangle, a rectangle, a circle, or a polygon.

This application further provides a display device, which includes the MicroLED display panel described above, and further includes a drive circuit and a controller. Each display structure is connected to one corresponding switch. The controller is configured to control the drive circuit to drive a status of the switch. The light emitting layer emits light when the switch is turned on.

In a possible implementation, the switch is a complementary metal oxide semiconductor CMOS switch or a thin film transistor TFT switch.

Based on the MicroLED display panel provided above, this application further provides a manufacturing method for the MicroLED display panel. Advantages of the display panel solutions described above are also applicable to the following method. Details are not described below again. The manufacturing method includes: obtaining a first semiconductor layer, a light emitting layer, and a second semiconductor layer that are sequentially stacked; etching the first semiconductor layer, the light emitting layer, and the second semiconductor layer to form the first semiconductor layer and the light emitting layer that are penetrated, and the second semiconductor layer that is partially penetrated; forming a first electrode on a side that is of the first semiconductor layer and that is away from the light emitting layer; and forming a second electrode on a side that is of the second semiconductor layer and that is away from the light emitting layer, where the second electrode is routed around each pixel region, the second electrode is a common electrode of each pixel region, and the second electrode serves as a metal barrier wall between adjacent pixel regions. The display panel manufactured by using the method does not require massive transfer, can be directly integrated with a switch, and is directly packaged subsequently, which reduces a process flow and facilitates productization.

In a possible implementation, the forming a first electrode specifically includes: opening a hole to deposit an ohmic electrode on the side that is of the first semiconductor layer and that is away from the light emitting layer, and performing evaporation on a reflective electrode, where the first electrode includes the ohmic electrode and the reflective electrode.

In a possible implementation, before the forming a first electrode, the method further includes: depositing a passivation layer. A chemical property of the passivation layer is stable, and therefore the passivation layer can implement a protection function.

In a possible implementation, the forming a second electrode on a side that is of the second semiconductor layer and that is away from the light emitting layer specifically includes: bonding the display panel to a first substrate via a bonding layer, to expose the second semiconductor layer, and forming the second electrode on the second semiconductor layer by routing around each pixel region.

In a possible implementation, after the forming the second electrode, the method further includes: performing bonding to transfer the display panel to a second substrate, and removing the first substrate, to expose the first electrode; and connecting the first electrode to a corresponding switch.

### This application has at least the following advantages:

The MicroLED display panel provided in this application uses a chip architecture of a vertical structure, and includes a plurality of display structures distributed in an array. Each display structure includes a first electrode, a second electrode, a light emitting layer, a first semiconductor layer, and a second semiconductor layer. The first semiconductor layer and the second semiconductor layer are respectively located on surfaces of two sides of the light emitting layer. The first electrode is located on a side that is of the first semiconductor layer and that is away from the light emitting layer, and the second electrode is located on a side that is of the second semiconductor layer and that is away from the light emitting layer. That is, the first electrode and the second electrode are respectively located on an upper surface and a lower surface of the chip. In this way, a light emitting region does not need to be etched to lead out the second electrode, and an area of the light emitting region is not wasted, thereby increasing the area of the light emitting region and facilitating improving light efficiency. Moreover, massive transfer does not need to be performed for a vertical structure in a semiconductor process, so that a product qualification rate can be ensured. In addition, the second electrode in this embodiment of this application is a common electrode and is routed around the pixel region. To be specific, the second electrode may serve as the metal barrier wall between pixel regions to prevent optical crosstalk between the pixel regions and facilitate pixelized routing of the second electrode. This can make current distribution more uniform, and further makes brightness of the display panel more uniform. No special procedure is needed in the process to manufacture the barrier wall, which reduces a process flow and facilitates productization.

### BRIEF DESCRIPTION OF DRAWINGS

FIG. 1 is a diagram of a MicroLED chip with a flip-chip structure;
FIG. 2 is a sectional view of a MicroLED display panel according to an embodiment of this application;
FIG. 3 is a top view corresponding to FIG. 2 according to an embodiment of this application;
FIG. 4a is another sectional view of a MicroLED display panel according to an embodiment of this application;
FIG. 4b is still another sectional view of a MicroLED display panel according to an embodiment of this application;
FIG. 5 is yet another sectional view of a MicroLED display panel according to an embodiment of this application;
FIG. 6 is still yet another sectional view of a MicroLED display panel according to an embodiment of this application;
FIG. 7 is a further sectional view of a MicroLED display panel according to an embodiment of this application;
FIG. 8 is a diagram of a structure of a first step of a manufacturing process of a MicroLED display panel according to an embodiment of this application;
FIG. 9 is a diagram of a structure of a second step of a manufacturing process of a MicroLED display panel according to an embodiment of this application;
FIG. 10 is a diagram of a structure of a third step of a manufacturing process of a MicroLED display panel according to an embodiment of this application;
FIG. 11 is a diagram of a structure of a fourth step of a manufacturing process of a MicroLED display panel according to an embodiment of this application;
FIG. 12 is a diagram of a display device according to an embodiment of this application; and
FIG. 13 is a flowchart of a manufacturing method for a MicroLED display panel according to an embodiment of this application.

### DESCRIPTION OF EMBODIMENTS

The following describes the technical solutions in embodiments of this application with reference to accompanying drawings in embodiments of this application.

In the following descriptions, terms such as "first" and "second" are merely intended for a purpose of description, and shall not be interpreted as an indication or implication of relative importance or an implicit indication of a quantity of indicated technical features. Therefore, a feature limited by "first", "second", or the like may explicitly or implicitly include one or more features. In the descriptions of this application, unless otherwise stated, "a plurality of" means two or more than two.

In this application, it should be noted that a term "connection" should be understood in a broad sense unless otherwise expressly specified and limited. For example, the "connection" may be a fixed connection, or may be a detachable connection or an integrated connection; and may be a direct connection, or may be an indirect connection through an intermediate medium. In addition, a term "coupling" may be a manner of implementing an electrical connection for signal transmission. The "coupling" may be a direct electrical connection, or may be an indirect electrical connection using an intermediate medium.

To make a person skilled in the art better understand the technical solutions provided in embodiments of this application, the following first describes an application scenario of the technical solutions.

An application scenario of a display panel is not specifically limited in embodiments of this application. The display panel uses a MicroLED for display. The display panel may be used in a display screen of a device, for example, a display screen of an electronic device such as a mobile phone, or a display screen of a wearable device such as a watch. In addition, the application scenario may further be a scenario with a large current and high pixel density, for example, a device such as a smart vehicle light, an AR device, or a VR device. In addition, the MicroLED may also be used as a pixelized array light source in fields such as photosensitivity, projection, and optical communication.

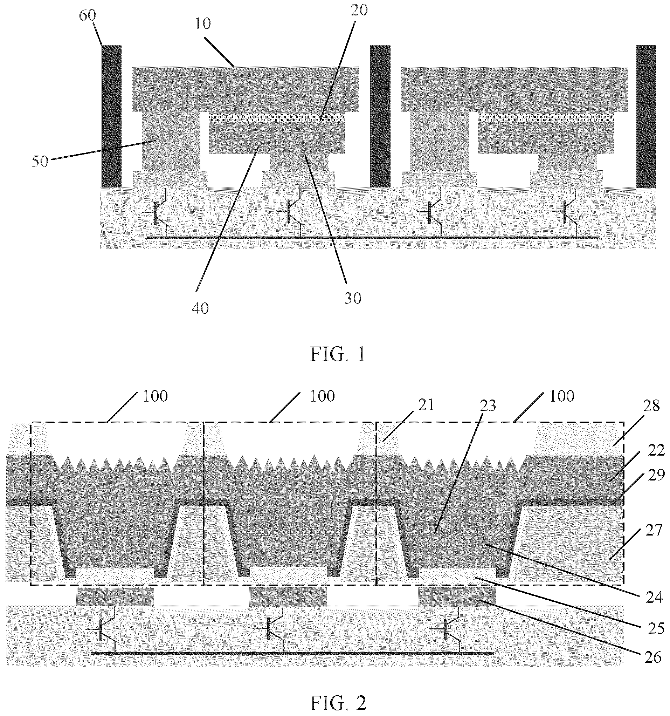

A conventional MicroLED chip uses a flip-chip structure with a mature process. FIG. 1 is a diagram of the MicroLED chip with the flip-chip structure.

It can be learned from FIG. 1 that two electrodes, a first electrode 30 and a second electrode 50, of a MicroLED chip with the flip-chip structure are distributed on a same side of a second semiconductor layer 10. In addition, the second electrode 50 can be led out only after a part of a light emitting region 20 is etched. As a result, a light emitting area is always less than a size of a single display unit, and efficiency is low in an application scenario with a large current and high pixel density. An increase in pixel density requires continuous reduction of a chip size, and efficiency of the flip-chip structure cannot be synchronized.

Therefore, to increase the light emitting area, the flip-chip structure cannot meet a requirement, and a barrier wall 60 needs to be disposed between adjacent display units to prevent light crosstalk. A barrier wall process is also difficult to implement in engineering.

In this application, to resolve a technical problem, in which the light emitting area is small and the barrier wall is difficult to implement in engineering, of the MicroLED chip with the flip-chip structure, a MicroLED display panel with a vertical structure is used. The first electrode and the second electrode of the display panel are not horizontally disposed, but are vertically disposed. The first electrode and the second electrode are respectively located on an upper surface and a lower surface of the second semiconductor layer. In this way, the part of the light emitting region does not need to be etched to lead out the second electrode. In addition, according to the display panel provided in this embodiment of this application, pixelized routing is performed for the second electrode in array display units of the entire display panel. That is, the second electrode is a common electrode of the display units, and the second electrode can implement a function of the barrier wall. This blocks light crosstalk between the display units, and no barrier wall needs to be separately disposed. A process is simple, and is easy to implement in engineering.

To make a person skilled in the art better understand the display panel provided in embodiments of this application, the following provides detailed descriptions with reference to the accompanying drawings.

FIG. 2 is a sectional view of a MicroLED display panel according to an embodiment of this application.

The MicroLED display panel provided in this embodiment of this application includes a plurality of display structures 100. As shown in a dashed-line box in FIG. 2, each display structure 100 includes a first electrode 25, a second electrode 21, a first semiconductor layer 24, a second semiconductor layer 22, and a light emitting layer 23. First electrodes 25, first semiconductor layers 24, and light emitting layers 23 of adjacent display structures 100 are independent of each other. That is, each display structure 100 is in a one-to-one correspondence with the first electrode 25, the first semiconductor layer 24, and the light emitting layer 23.

Whether each display structure 100 is in a one-to-one correspondence with the second semiconductor layer 22 is not specifically limited in this embodiment of this application. To be specific, second semiconductor layers 22 of the display structures 100 may be independent of each other, or second semiconductor layers 22 corresponding to all the display structures 100 may be communicated. **In** this embodiment, an example in which the second semiconductor layers 22 of all the display structures 100 are communicated is used for description.

The first semiconductor layer 24 and the second semiconductor layer 22 are respectively located on surfaces of two sides of the light emitting layer 23. The first electrode 25 is located on a side that is of the first semiconductor layer 24 and that is away from the light emitting layer 23, and the second electrode 21 is located on a side that is of the second semiconductor layer 22 and that is away from the light emitting layer 23.

The first electrode 25 is configured to connect to a switch corresponding to the display structure 100. As shown in the figure, a metal solder joint 26 is further disposed between the first electrode 25 and the switch. It should be understood that each display structure 100 corresponds to one switch, and a status of the switch determines whether the light emitting layer emits light. For example, when the switch is turned on, the light emitting layer emits light; and when the switch is turned off, the light emitting layer does not emit light. Control of the switch is controlled by a drive circuit. The drive circuit may receive a control signal of a controller of a device, and further generate a drive signal based on the control signal, to drive the status of the switch.

The first electrode 25 is a surface electrode, and the first electrode 25 wraps a surface and a side wall of the first semiconductor layer 24. For example, the first electrode 25 fully wraps a surface and all the side walls of the first semiconductor. The first electrode 25 is the surface electrode that has functions of both an electric field and light reflection, so that a light emitting angle can be effectively reduced, light collection can be implemented, forward brightness of a chip can be improved, and light efficiency can be improved.

Both the first semiconductor layer 24 and the second semiconductor layer 22 are carrier transport layers. A charged polarity of the first semiconductor layer 24 is the same as a polarity of the first electrode 25, and edge charges repel each other, which can effectively reduce side wall effect. A charged polarity of the second semiconductor layer 22 is the same as a polarity of the second electrode 21. The second semiconductor layer 22 is charged and is electrically opposite to the first electrode 25, and edge charges absorb each other, which facilitates extension of a current and improves efficiency.

The surface and the side wall of the first semiconductor layer 24 may be provided with a reflection layer, and are wrapped by the reflection layer. The reflection layer is a thin film material having high reflectivity, for example, a metal reflector or a metal and distributed Bragg reflection (DBR, Distributed Bragg Reflection) composite layer.

A type of the switch is not specifically limited in this application. For example, the switch may be a complementary metal oxide semiconductor (CMOS, Complementary Metal-Oxide-Semiconductor) switch or a thin film transistor (TFT, Thin Film Transistor), or may be another type of switch transistor. The CMOS has more advantages than the TFT. Therefore, the CMOS is preferably used as a switch, for example, a silicon Si CMOS. Silicon has good heat resistance and is especially suitable for application in a vehicle light scenario. In addition, the CMOS and the display structure can be integrated in the chip, to implement wafer-level integration with no need for massive transfer. In scenarios in which a large current is required, such as a vehicle light, a current of the TFT cannot meet the requirement, and a current of a single chip is excessively small. The CMOS is suitable for application in a large-current high-density scenario, and can meet a current requirement and a heat resistance requirement.

Each display structure further includes a bonding layer 27 and a passivation layer 29.

The light emitting layer 23 of each display structure corresponds to one pixel region.

The second electrode 21 is routed around each pixel region, the second electrode 21 is a common electrode of each pixel region, and the second electrode 21 is configured to serve as a metal barrier wall between adjacent pixel regions. That is, the display structures 100 share the second electrode 21. Second electrodes 21 of the display structures 100 may be integrally formed during processing and manufacturing.

Because the second electrode 21 encloses each pixel region in a sealed manner, the second electrode 21 implements a function of a barrier wall, so that each pixel region can independently emit light, thereby effectively preventing light crosstalk between pixel regions.

In addition, a pad region 28 for the second electrode is reserved at an edge of the display panel. For details, refer to a rightmost display structure 100 that is located at the edge of the display panel in FIG. 2.

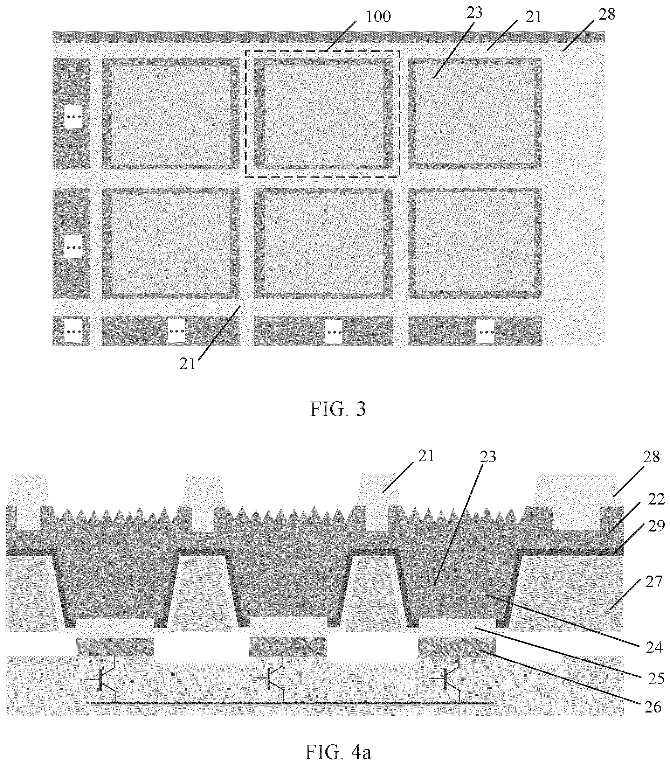

With reference to a top view shown in FIG. 3, in the following description, disposing of the second electrode in the display panel provided in this embodiment of this application may be more intuitively understood.

FIG. 3 is the top view corresponding to FIG. 2 according to an embodiment of this application.

It can be learned from FIG. 3 that each pixel region 23 corresponds to one pixel region, and pixelized routing is arranged for the second electrode 21 along with the pixel region. That is, a periphery of each pixel region is enclosed by the second electrode 21, and the second electrodes 21 of all the pixel regions are communicated. That is, the second electrode 21 serves as a common electrode of all the display structures 100. It can be learned from FIG. 3 that the second electrode 21 is routed around each pixel region in a sealed manner, so that light can be effectively blocked between adjacent pixel regions.

A shape of the second electrode corresponding to each pixel region is not specifically limited in this embodiment of this application. The shape of the second electrode may be any one of the following: a triangle, a rectangle, a circle, or a polygon, or may be another shape. Details are not described herein again. The rectangle includes a square. An example in which the shape of the second electrode 21, shown in FIG. 2, routed around the pixel region is a rectangle is used for description.

It can be intuitively learned from FIG. 3 that the second electrode 21 serves as the barrier wall of each pixel region, and prevents mutual light crosstalk between the pixel regions, thereby implementing a function of light isolation. Therefore, a special process for separately disposing a barrier wall, which is required by the structure shown in FIG. 1, is not required. The display panel provided in this embodiment of this application reduces a process flow, and is easy to implement in engineering.

Therefore, the MicroLED display panel provided in this embodiment of this application uses a chip architecture of a vertical structure. The first electrode and the second electrode are respectively located on an upper surface and a lower surface of the chip. In this way, a light emitting region does not need to be etched to lead out the second electrode, and an area of the light emitting region is not wasted, thereby increasing the area of the light emitting region and facilitating improving light efficiency. Moreover, massive transfer does not need to be performed for a vertical structure in a semiconductor process, so that a product qualification rate can be ensured. In addition, the second electrode in this embodiment of this application is a common electrode and is routed around the pixel region. To be specific, the second electrode may serve as the metal barrier wall between pixel regions to prevent optical crosstalk between the pixel regions and facilitate pixelized routing of the second electrode. This can make current distribution more uniform, and further makes brightness of the display panel more uniform. No special procedure is needed in the process to manufacture the barrier wall, which reduces a process flow and facilitates engineering.

Still refer to FIG. 2. A side surface of the second electrode 21 is tilted, and a tilt angle range is 30 degrees to 150 degrees. The tilt angle of the side surface of the second electrode 21 shown in FIG. 2 is an acute angle. That is, a section of the second electrode 21 shown in FIG. 2 is a regular trapezoid. It should be understood that the tilt angle may also be an obtuse angle, and correspondingly, the section of the second electrode 21 is an inverted trapezoid.

A side wall of the second electrode 21 is designed in a tilt manner, which helps collect light and improve light efficiency.

In addition, according to the MicroLED display panel provided in this embodiment of this application, a side wall of the display structure is tilted, and the tilt angle range is 30 degrees to 150 degrees. When the side wall is consistent with the tilt angle of the second electrode, light can be collected, and titling of the side wall helps drain a current and prevent current congestion.

In this embodiment of this application, whether the tilt angle of the side wall of the second electrode is consistent with that of the display structure is not specifically limited, and tilt directions may be different. For example, the second electrode is an inverted trapezoid, and the side wall of the display structure is a regular trapezoid.

In addition, to improve luminous efficiency and reduce light reflection, a surface of the side that is of the second semiconductor and that is away from the light emitting layer presents a crystal structure. A specific shape of the crystal structure is not specifically limited in this embodiment of this application. For example, the crystal structure may be in a sawtooth shape shown in FIG. 2, or may be in a wave shape or the like. If the side that is of the second semiconductor and that is away from the light emitting layer is a plane, the emitted light is reflected, and light emitting is affected.

The following describes several specific implementations of the second electrode of the MicroLED display panel provided in embodiments of this application with reference to the accompanying drawings.

FIG. 4a is another sectional view of a MicroLED display panel according to an embodiment of this application.

To further isolate light between adjacent display structures, a side that is of a second electrode and that is in contact with a second semiconductor layer is partially or completely embedded into the second semiconductor layer.

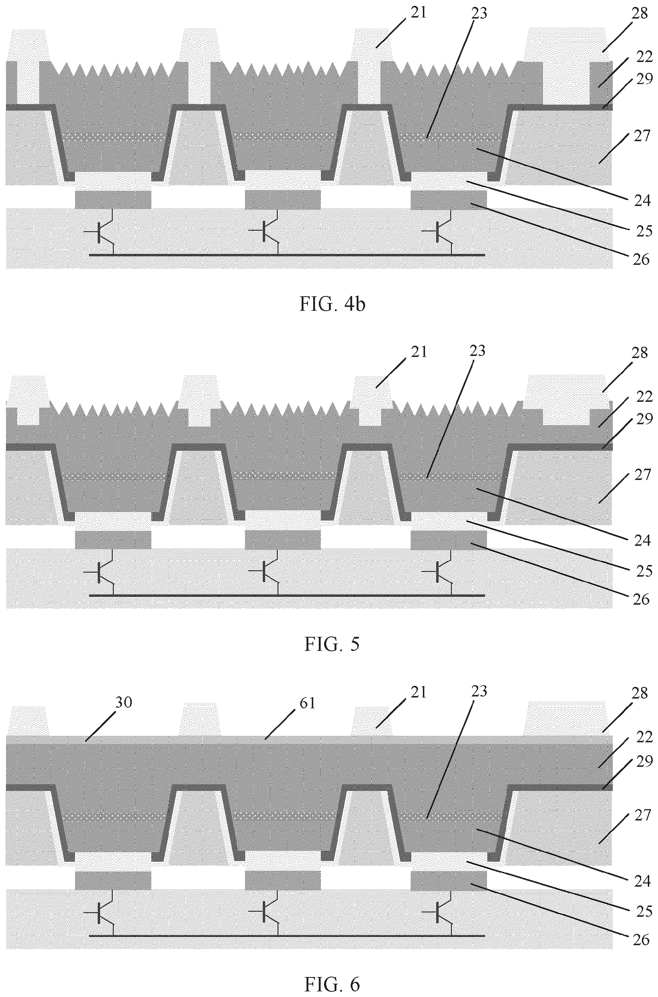

**In** FIG. 4a, a side that is of a second electrode 21 and that is in contact with a second semiconductor layer 22 is partially embedded into the second semiconductor layer 22. **In** addition, a depth at which the second electrode 21 is embedded into the second semiconductor layer 22 is not specifically limited in this embodiment of this application. It should be understood that a greater depth in which the second electrode 21 is embedded indicates poorer light blocking effect. For example, after being embedded into the second semiconductor layer 22, the second electrode 21 may be in contact with a passivation layer 29, as shown in FIG. 4b. **In** this case, second semiconductor layers 22 between display structures are no longer communicated, and are isolated by the second electrode 21.

It may be understood that as shown in FIG. 5, a surface that is of the second electrode 21 and that is in contact with the second semiconductor layer 22 may be completely embedded into the second semiconductor layer 22.

**In** addition, a specific shape in which the second electrode 21 is embedded into the second semiconductor layer 22 is not specifically limited in this embodiment of this application. A person skilled in the art may set the shape based on an actual requirement.

According to the display panel provided in this embodiment of this application, the second electrode 21 is used to implement a function of the barrier wall, to implement light isolation between the pixel regions. **In** other words, a process in which light crosstalk is prevented can be completed at a chip level, thereby bringing a high yield rate of a product. **In** addition, the chip can be continuously scaled down to cover applications in a plurality of scenarios, for example, tens of thousands of pixels, millions of pixels, or even tens of millions of pixels.

**In** addition, a bonding layer 27 is provided between the display structures for filling. Because the bonding layer 27 is non-conductive, electricity isolation can be implemented, and strength of the display panel can be improved.

A first electrode 25 is a surface electrode, and the first electrode 25 wraps a surface and a side wall of a first semiconductor layer 24.

The second semiconductor layers 22 of the display structures are communicated. The thickness of the second semiconductor layer 22 at a joint of adjacent display structures may be greater than a coarsening depth, to prevent a chip from breaking.

A passivation layer 29 is deposited on etched edges of the second semiconductor layer 22, the light emitting layer 23, and the first semiconductor layer 24. A side that is of the second electrode 21 and that is embedded into the second semiconductor layer 22 is in contact with the passivation layer 29.

A chemical property of the passivation layer 29 is stable, and therefore the passivation layer 29 can implement a protection function.

The first electrode 25 of the display panel provided in this embodiment of this application includes an ohmic electrode and a reflective electrode.

The ohmic electrode is configured to connect to the first semiconductor layer 24.

The reflective electrode is connected to a drive circuit, and is specifically connected to a switch via a metal solder joint. The reflective electrode is further configured to reflect light.

To further improve a transmittance, the display panel provided in this embodiment of this application further includes a transparent conductive layer. The following provides detailed descriptions with reference to the accompanying drawings.

FIG. 6 is still yet another sectional view of a MicroLED display panel according to an embodiment of this application.

It can be learned from FIG. 6 that the display panel further includes a transparent conductive layer 30 that is disposed between a second semiconductor layer 22 and a second electrode 21.

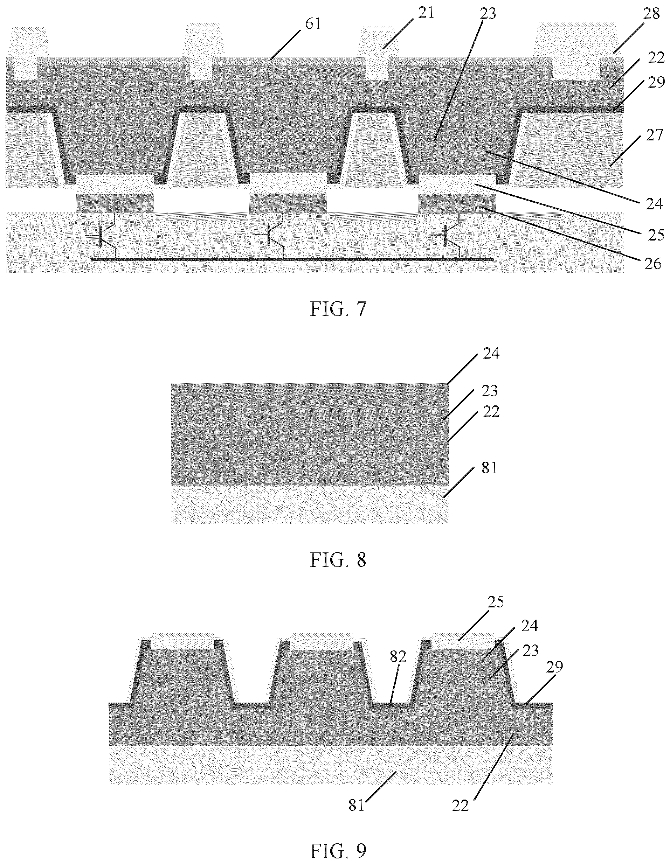

A side that is of the second electrode 21 and that is in contact with a transparent conductive layer 30 is at least partially embedded into the transparent conductive layer 30. To be specific, to improve light blocking effect of the second electrode 21, the second electrode may also be embedded into the transparent conductive layer 30, or may be embedded into the transparent conductive layer 30 and the second semiconductor layer 22. For details, refer to FIG. 7. FIG. 7 is a further sectional view of a MicroLED display panel according to an embodiment of this application. A lower end of a second electrode 21 in FIG. 7 passes through a transparent conductive layer 30 and is embedded into a second semiconductor layer 22.

To reduce ohmic resistance between the second semiconductor layer 22 and the second electrode 21, the transparent conductive layer 30 is added to the surface of the second semiconductor layer 22, and then the second electrode 21 is formed on the transparent conductive layer 30.

According to the display panel provided in this embodiment of this application, the transparent conductive layer 30 is added. The transparent conductive layer 30 serves as a transition between the second electrode and the second semiconductor layer, which resolves a problem of ohmic contact between metal and a semiconductor, and can reduce a resistance value. **In** addition, the transparent conductive layer 30 is distributed on an entire surface, which helps more uniformly extend a current, and can also improve the light efficiency, thereby avoiding a problem of uneven brightness and improving reliability of the display panel. **In** addition, the transparent conductive layer 30 in combination with the second electrode 21 routed in a pixelized manner can reduce a power, reduce a voltage, and reduce power consumption.

A material of the transparent conductive layer 30 is not specifically limited in this embodiment of this application. For example, indium tin oxide (ITO), indium zinc oxide (IZO), or the like may be selected for the transparent conductive layer 30.

The transparent conductive layer 30 provided in this embodiment of this application may be separately disposed. Alternatively, the transparent conductive layer 30 and the sawtooth-shaped crystal structure shown in FIG. 5 may be jointly used to improve luminous efficiency. This is not specifically limited in this embodiment of this application.

To make a person skilled in the art to better understand the MicroLED display panel provided in embodiments of this application, the following describes a manufacturing process in detail with reference to the accompanying drawings. With reference to the manufacturing process, it may be more clearly understood that the technical solution provided in embodiments of this application reduces a process flow, and is easy to implement in engineering.

FIG. 8 is a diagram of a structure of a first step of the manufacturing process of the MicroLED display panel according to an embodiment of this application.

Obtain, on a substrate 81, a first semiconductor layer 24, a light emitting layer 23, and a second semiconductor layer 22 that are sequentially stacked.

First, clean a wafer surface for an epitaxial wafer, to ensure that the surface is clean.

FIG. 9 is a diagram of a structure of a second step of the manufacturing process of the MicroLED display panel according to an embodiment of this application.

Perform inductively coupled plasma (ICP, Inductively Coupled Plasma) dry etching on a photo-etched chip. Etching sequentially passes through the first semiconductor layer 24, the light emitting layer 23, and the second semiconductor layer 22, to form the first semiconductor layer 24 and the light emitting layer 23 that are penetrated, and the second semiconductor layer 22 that is partially penetrated. That is, a part of the second semiconductor layer 22 is not penetrated, and the second semiconductor layers 22 of the display structures may be communicated. Then, deposit a passivation layer 29. A chemical property of the passivation layer 29 is stable, and therefore the passivation layer 29 can implement a protection function.

Form a first electrode 25 on a side that is of the first semiconductor layer 24 and that is away from the light emitting layer 23, which may specifically include: opening a hole to deposit an ohmic electrode, and then performing evaporation on a reflective electrode. Both the ohmic electrode and the reflective electrode belong to the first electrode 25. The ohmic electrode is configured to connect to a switch. The reflective electrode is configured to reflect light and connect to the first semiconductor layer 24.

The following describes a specific manufacturing process of the second electrode.

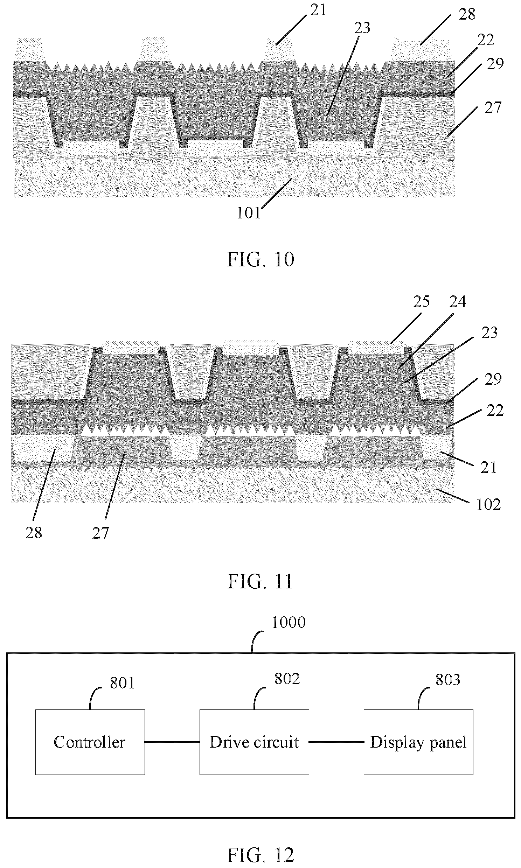

FIG. 10 is a diagram of a structure of a third step of the manufacturing process of the MicroLED display panel according to an embodiment of this application.

Form a second electrode 21 on a side that is of the second semiconductor layer 21 and that is away from the light emitting layer 23, where the second electrode 21 is routed around each pixel region, the second electrode 21 is a common electrode of each pixel region, and the second electrode 21 serves as a metal barrier wall between adjacent pixel regions.

Perform bonding on a wafer to bond the wafer to a first substrate 101 via a bonding layer 27, remove the original substrate, and expose the second semiconductor layer 22. Manufacture a pixelized metal routing on the second semiconductor layer 22, to complete crystal structure processing such as coarsening on the second electrode 21 and a region other than the second electrode 21. In FIG. 10, a sawtooth shape of the surface of the second semiconductor layer 22 represents a coarsening structure, which can reduce total reflection of emergent light and improve luminous efficiency. The surface of the second semiconductor layer 22 may also use a shape of another crystal structure, and details are not described herein again.

FIG. 11 is a diagram of a structure of a fourth step of the manufacturing process of the MicroLED display panel according to an embodiment of this application.

Perform bonding for another time to transfer the chip to the second substrate 102, and then remove the first substrate, to expose the first electrode 25.

After the first electrode 25 is exposed, still refer to FIG. 2. The first electrode 25 is connected to a metal solder joint of the switch through a bonding process, so that the chip is integrated with a drive circuit of the switch, and can be directly packaged subsequently. The display panel provided in this embodiment of this application does not require massive transfer, and may be directly encapsulated.

Based on the MicroLED display panel provided in the foregoing embodiments, an embodiment of this application further provides a display device. The following describes the display device provided in this embodiment of this application with reference to the accompanying drawings.

FIG. 12 is a diagram of the display device according to an embodiment of this application.

A specific application scenario of a display device 1000 is not specifically limited in this embodiment of this application. For example, the display device 1000 may be a display screen, or may be an electronic device having a display screen, for example, an AR product, a VR product, or a smart vehicle light.

The display device 1000 provided in this embodiment of this application includes the MicroLED display panel 803 described in the foregoing embodiments, and further includes a drive circuit 802 and a controller 801.

The MicroLED display panel 803 includes a plurality of switches. Each display structure corresponds to one switch. The switch is configured to control whether a light emitting region emits light.

Each display structure is connected to one corresponding switch. Each display structure corresponds to one pixel region, and the display structures are arranged in an array. The display device provided in this embodiment of this application does not specifically limit a size of the display panel. The size may be set based on an actual requirement. In addition, a quantity of display structures of the display panel is also not limited.

The controller 801 is configured to control the drive circuit 802 to drive a status of a switch of the MicroLED display panel. The light emitting layer emits light when the switch is turned on.

In an actual product, the controller 801 and the drive circuit 802 may be located on a control integrated circuit IC. The control IC is configured to control the MicroLED display panel 803 for display.

Because the display device provided in this embodiment of this application includes the MicroLED display panel described above, and the MicroLED display panel uses a chip architecture of a vertical structure, an area of the light emitting region is increased. This helps improve light efficiency and reduce a size of a product, and more electrons and holes can be accommodated in a unit area. In addition, the second electrode is a common electrode and is routed around the pixel region, and may serve as a metal barrier wall between pixel regions to prevent light crosstalk between the pixel regions. This makes current distribution more uniform and brightness more uniform. No special procedure is needed in the process to manufacture the barrier wall, a complex process of massive transfer is not needed, which reduces a process flow and facilitates implementing productization. When the switch is a CMOS switch, the switch is especially suitable for application in a scenario with a large current and high pixel density, which facilitates reduction of a product size.

Based on the MicroLED display panel and the display apparatus that are provided in the foregoing embodiments, an embodiment of this application further provides a manufacturing method for the MicroLED display panel. The following describes the method in detail with reference to the accompanying drawings.

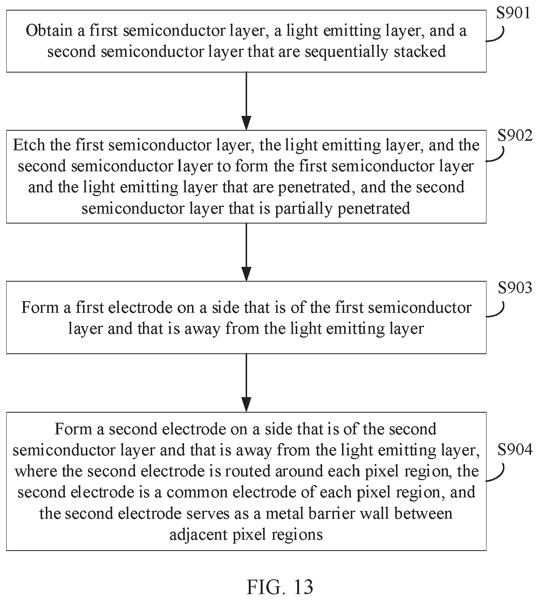

FIG. 13 is a flowchart of the manufacturing method for the MicroLED display panel according to an embodiment of this application.

This embodiment of this application provides the manufacturing method for the MicroLED display panel, including the following steps.

S1301: Obtain a first semiconductor layer, a light emitting layer, and a second semiconductor layer that are sequentially stacked. First, clean a wafer surface for an epitaxial wafer, to ensure that the surface is clean.

S1302: Etch the first semiconductor layer, the light emitting layer, and the second semiconductor layer to form the first semiconductor layer and the light emitting layer that are penetrated, and the second semiconductor layer that is partially penetrated. ICP dry etching may be used to perform etching.

S1303: Form a first electrode on a side that is of the first semiconductor layer and that is away from the light emitting layer.

Forming the first electrode specifically includes:
opening a hole to deposit an ohmic electrode on the side that is of the first semiconductor layer and that is away from the light emitting layer, and performing evaporation on a reflective electrode, where the first electrode includes the ohmic electrode and the reflective electrode. The ohmic electrode is configured to connect to a switch. The reflective electrode is configured to reflect light and connect to the first semiconductor layer.

Before the first electrode is formed, the method further includes:
depositing a passivation layer. A chemical property of the passivation layer is stable, and therefore the passivation layer can implement a protection function.

S1304: Form a second electrode on a side that is of the second semiconductor layer and that is away from the light emitting layer, where the second electrode is routed around each pixel region, the second electrode is a common electrode of each pixel region, and the second electrode serves as a metal barrier wall between adjacent pixel regions.

That form a second electrode on a side that is of the second semiconductor layer and that is away from the light emitting layer specifically includes:
bonding the display panel to a first substrate via a bonding layer, to expose the second semiconductor layer, and forming the second electrode on the second semiconductor layer by routing around each pixel region.

After the second electrode is formed, the method further includes:
performing bonding to transfer the display panel to a second substrate, and removing the first substrate, to expose the first electrode.

After the first electrode is exposed, the first electrode is connected to a metal solder joint of the switch through a bonding process, so that the chip is integrated with a drive circuit of the switch, and can be directly packaged subsequently.

For a specific procedure of the manufacturing method for the MicroLED display panel, refer to descriptions of FIG. 8 to FIG. 10. Details are not described herein again.

Therefore, according to the manufacturing method for the MicroLED display panel provided in this embodiment of this application, the reflective electrode of the first electrode is manufactured on the first semiconductor layer, and the pixelized second electrode is manufactured on the second semiconductor layer. That is, only pixelized metal routing is performed on the second electrode. The second electrode serves as the barrier wall between pixel regions, and no barrier wall needs to be specially manufactured, thereby reducing the process flow. Finally, the chip is bonded to a silicon-based CMOS switch. The display panel manufactured by using the method does not require massive transfer, can be directly integrated with a switch, and is directly packaged subsequently, which reduces a process flow and facilitates implementing productization.

It should be understood that in this application, "at least one (item)" refers to one or more and "a plurality of" refers to two or more. The term "and/or" is used for describing an association relationship between associated objects, and represents that three relationships may exist. For example, "A and/or B" may represent the following three cases: Only A exists, only B exists, and both A and B exist, where A and B may be singular or plural. The character "/" generally indicates an "or" relationship between the associated objects. "At least one of the following items (pieces)" or a similar expression thereof refers to any combination of these items, including any combination of singular items (pieces) or plural items (pieces). For example, at least one item (piece) of a, b, or c may indicate a, b, c, a and b, a and c, b and c, or a, b, and c, where a, b, and c may be singular or plural.

The foregoing descriptions are merely preferred embodiments of this application, but are not intended to limit this application in any form. Although the preferred embodiments of this application are disclosed above, embodiments are not intended to limit this application. By using the method and the technical content disclosed above, any person skilled in the art can make a plurality of possible changes and modifications on the technical solutions of this application, or amend the technical solutions thereof to be embodiments with equal effects through equivalent variations without departing from the protection scope of the technical solutions of this application. Therefore, any simple amendment, equivalent variation, and modification made on the above embodiments according to the technical essence of this application without departing from the content of the technical solutions of this application shall still fall within the protection scope of the technical solutions of this application.

## Claims

1. A MicroLED display panel, comprising a plurality of display structures, wherein each display structure comprises a first electrode, a second electrode, a first semiconductor layer, a second semiconductor layer, and a light emitting layer;
the first electrodes, the first semiconductor layers, and the light emitting layers of adjacent display structures are independent of each other;
the first semiconductor layer and the second semiconductor layer are respectively located on surfaces of two sides of the light emitting layer; the first electrode is located on a side that is of the first semiconductor layer and that is away from the light emitting layer, and the second electrode is located on a side that is of the second semiconductor layer and that is away from the light emitting layer;
the light emitting layer of each display structure corresponds to one pixel region; and
the second electrode is routed around each pixel region, the second electrode is a common electrode of each pixel region, and the second electrode is configured to serve as a metal barrier wall between adjacent pixel regions.

2. The display panel according to claim 1, wherein a side surface of the second electrode is tilted, and a tilt angle range is 30 degrees to 150 degrees.

3. The display panel according to claim 2, wherein a side wall of the display structure is tilted, and a tilt angle range is 30 degrees to 150 degrees.

4. The display panel according to claim 1 or 2, wherein the second electrode in contact with the second semiconductor layer is partially or completely embedded into the second semiconductor layer.

5. The display panel according to claim 4, wherein a passivation layer is deposited on etched edges of the second semiconductor layer, the light emitting layer, and the first semiconductor layer, and a side that is of the second electrode and that is embedded into the second semiconductor layer is in contact with the passivation layer.

6. The display panel according to any one of claims 1 to 5, further comprising a transparent conductive layer that is disposed between the second semiconductor layer and the second electrode.

7. The display panel according to claim 6, wherein a side that is of the second electrode and that is in contact with the transparent conductive layer is at least partially embedded into the transparent conductive layer;
or
a side that is of the second electrode and that is in contact with the transparent conductive layer is at least partially embedded into the transparent conductive layer and the second semiconductor layer.

8. The display panel according to claims 1 to 5, wherein a surface of a side that is of the second semiconductor and that is away from the light emitting layer presents a crystal structure.

9. The display panel according to any one of claims 1 to 7, wherein the first electrode is a surface electrode, and the first electrode wraps a surface and a side wall of the first semiconductor;
the display panel further comprises a plurality of switches; and
each display structure corresponds to one switch, and the first electrode is configured to connect to the corresponding switch.

10. The display panel according to any one of claims 1 to 9, wherein the second semiconductor layers of the display structures are communicated; and
both the first semiconductor layer and the second semiconductor layer are carrier transport layers, a charged polarity of the first semiconductor layer is the same as a polarity of the first electrode, and a charged polarity of the second semiconductor layer is the same as a polarity of the second electrode.

11. The display panel according to any one of claims 1 to 10, wherein the first electrode comprises an ohmic electrode and a reflective electrode;
the ohmic electrode is configured to connect to the first semiconductor layer; and
the reflective electrode is connected to a drive circuit, and the reflective electrode is further configured to reflect light.

12. The display panel according to any one of claims 1 to 11, wherein a shape of the second electrode is any one of the following:
a triangle, a rectangle, a circle, or a polygon.

13. A display device, comprising the MicroLED display panel according to any one of claims 1 to 12, and further comprising a drive circuit and a controller, wherein
each display structure is connected to one corresponding switch; and
the controller is configured to control the drive circuit to drive a status of the switch, wherein the light emitting layer emits light when the switch is turned on.

14. The display device according to claim 13, wherein the switch is a complementary metal oxide semiconductor CMOS switch or a thin film transistor TFT.

15. A manufacturing method for a MicroLED display panel, comprising:
obtaining a first semiconductor layer, a light emitting layer, and a second semiconductor layer that are sequentially stacked;
etching the first semiconductor layer, the light emitting layer, and the second semiconductor layer to form the first semiconductor layer and the light emitting layer that are penetrated, and the second semiconductor layer that is partially penetrated;
forming a first electrode on a side that is of the first semiconductor layer and that is away from the light emitting layer; and
forming the second electrode on a side that is of the second semiconductor layer and that is away from the light emitting layer, wherein the second electrode is routed around each pixel region, the second electrode is a common electrode of each pixel region, and the second electrode serves as a metal barrier wall between adjacent pixel regions.

16. The manufacturing method according to claim 15, wherein the forming a first electrode specifically comprises:
opening a hole to deposit an ohmic electrode on the side that is of the first semiconductor layer and that is away from the light emitting layer, and performing evaporation on a reflective electrode, wherein the first electrode comprises the ohmic electrode and the reflective electrode.

17. The manufacturing method according to claim 15 or 16, wherein before the forming a first electrode, the method further comprises:
depositing a passivation layer.

18. The manufacturing method according to claim 15, wherein the forming the second electrode on a side that is of the second semiconductor layer and that is away from the light emitting layer specifically comprises:
bonding the display panel to a first substrate via a bonding layer, to expose the second semiconductor layer, and forming the second electrode on the second semiconductor layer by routing around each pixel region.

19. The manufacturing method according to claim 18, wherein after the forming the second electrode, the method further comprises:
performing bonding to transfer the display panel to a second substrate, and removing the first substrate, to expose the first electrode; and
connecting the first electrode to a corresponding switch.
